# EUROPEAN PATENT SPECIFICATION

(11) **EP 2 869 391 B1**
(45) Date of publication and mention of the grant of the patent: **04.01.2017**
(21) Application number: 14190352.6
(22) Date of filing: 24.10.2014
(51) Int. Cl.: H01M 10/42, H01M 10/48

(54) **Electronic apparatus, battery protection method and device**
Elektronische Vorrichtung, Batterieschutzverfahren und Vorrichtung
Appareil électronique, dispositif et procédé de protection de batterie

(30) Priority: 29.10.2013 CN 201310520503
(43) Date of publication of application: 06.05.2015
(73) Proprietor: Xiaomi Inc., Beijing 100085 (CN)
(72) Inventor: Zheng, Zhongxiang, 100085 Haidian District (CN); Zhang, Jianjun, 100085 Haidian District (CN); Li, Jinchao, 100085 Haidian District (CN)
(74) Representative: Robson, Aidan John

(56) References cited:
- DE-A1-102010 012 936
- JP-A- 2011 009 042
- US-A- 4 025 696
- US-A- 6 163 134
- US-A1- 2010 026 609
- US-A1- 2013 093 383

## Description

### TECHNICAL FIELD

The present disclosure relates to the field of electronic apparatus, and more particularly, to an electronic apparatus, a battery protection method and device.

### BACKGROUND

With rapid development of the mobile terminals, especially the explosive growth of the electronic apparatuses such as mobile phones and tablet computers, the safety issues of these electronic apparatuses have gradually been put on the agenda on the premise that the functions of the electronic apparatuses sufficiently meet the user's requirements. For example, the battery protection issues have become more and more important.

At present, the battery protection is mainly performed by: detecting whether the input or output current of the battery exceeds a certain limit via a detection circuit provided inside the battery, and triggering a protection circuit inside the battery if the input or output current of the battery exceeds the certain limit. The protection circuit is used for cutting off the charging circuit or electricity supplying circuit inside the battery, so as to realize the protection of the battery. In addition, the battery protection can also be achieved by detecting the input or output voltage of the battery.

During the inventor's implementation of the present disclosure, at least the following defects are found in the related art: even if there is no current input or output, or no voltage input or output in the battery, the battery still needs a protection. For example, in the case that an external force is applied to the battery, or the interior of the battery expands due to a lot of heat produced by the chemical reaction inside the battery, the battery is easily to be damaged, even the risk of an explosion of the battery may occur.

US 2010/0026609 relates to a battery accommodating device for preventing excessive pressure acting on the battery by unlocking a battery chamber cover member when the battery has expanded.

### SUMMARY

In order to solve the safety hazard existing when the battery is impacted or is extruded which is not solved by the related art, the embodiments of the present disclosure provide an electronic apparatus, a battery protection method and device. The technical solutions are as follows.

According to a first aspect of embodiments of the present disclosure, there is provided an electronic apparatus, including: a battery, at least one pressure sensor provided on a surface of the battery, and a controller electrically connected with the pressure sensor;
the pressure sensor samples a pressure parameter on the surface of the battery;
the controller acquires the pressure parameter on the surface of the battery, detects a magnitude relation between the pressure parameter and a predefined threshold value, and generates a control instruction for protecting the battery based on the detected result.

The controller detects, at a predetermined time interval, the magnitude relations between the pressure parameter and a first threshold value, a second threshold value, and a third threshold value which increase progressively; and
the controller generates a reminder information displaying instruction for triggering the electronic apparatus to issue a reminder alert via a display screen, a speaker and/or a signal lamp, if the detected result is that the pressure parameter is larger than the first threshold value and smaller than the second threshold value; generates a sleep instruction for triggering the battery to enter into a sleep state, if the detected result is that the pressure parameter is larger than the second threshold value and smaller than the third threshold value; and generates a permanent failure instruction for triggering the battery to enter into a permanent failure state, if the detected result is that the pressure parameter is larger than the third threshold value.

The controller detects whether the pressure parameter recovers to be smaller than the second threshold value after the battery enters into the sleep state, and generates a sleep recover instruction for triggering the battery to recover from the sleep state to a normal operating state if the detected result is that the pressure parameter is smaller than the second threshold value.

In a possible implementation, the at least one pressure sensors are provided uniformly at different positions on the surface of the battery, and the predefined threshold values to which the pressure sensors at different positions respectively correspond are the same or different.

According to a second aspect of embodiments of the present disclosure, there is provided a battery protection method used in a controller, the method including:
acquiring a pressure parameter on a surface of a battery;
detecting a magnitude relation between the pressure parameter and a predefined threshold value; and
generating a control instruction for protecting the battery based on the detected result.

The "detecting a magnitude relation between the pressure parameter and a predefined threshold value; and generating a control instruction for protecting the battery based on the detected result" includes:
detecting, at a predetermined time interval, the magnitude relations between the pressure parameter and a first threshold value, a second threshold value, and a third threshold value which increase progressively;
generating a reminder information displaying instruction for triggering an electronic apparatus to issue a reminder alert via a display screen, a speaker and/or a signal lamp, if the detected result is that the pressure parameter is larger than the first threshold value and smaller than the second threshold value;
generating a sleep instruction for triggering the battery to enter into a sleep state, if the detected result is that the pressure parameter is larger than the second threshold value and smaller than the third threshold value; and
generating a permanent failure instruction for triggering the battery to enter into a permanent failure state, if the detected result is that the pressure parameter is larger than the third threshold value.

The method further includes:
detecting whether the pressure parameter recovers to be smaller than the second threshold value after the battery enters into the sleep state; and
generating a sleep recover instruction for triggering the battery to recover from the sleep state to a normal operating state if the detected result is that the pressure parameter is smaller than the second threshold value.

According to a third aspect of embodiments of the present disclosure, there is provided a battery protection device used in a controller, the device including:
a pressure acquiring module configured to acquire a pressure parameter on a surface of a battery;
a pressure detection module configured to detect a magnitude relation between the pressure parameter and a predefined threshold value; and
an instruction generation module configured to generate a control instruction for protecting the battery based on the detected result.

The pressure detection module is further configured to detect, at a predetermined time interval, the magnitude relations between the pressure parameter and a first threshold value, a second threshold value, and a third threshold value which increase progressively;
the instruction generation module includes an alert generation unit, a sleep generation unit, and a failure generation unit;
the alert generation unit is configured to generate a reminder information displaying instruction for triggering an electronic apparatus to issue a reminder alert via a display screen, a speaker and/or a signal lamp, if the detected result is that the pressure parameter is larger than the first threshold value and smaller than the second threshold value;
the sleep generation unit is configured to generate a sleep instruction for triggering the battery to enter into a sleep state, if the detected result is that the pressure parameter is larger than the second threshold value and smaller than the third threshold value; and
the failure generation unit is configured to generate a permanent failure instruction for triggering the battery to enter into a permanent failure state, if the detected result is that the pressure parameter is larger than the third threshold value.

The instruction generation module further includes a pressure detection unit and a recovery generation unit;
the pressure detection unit is configured to detect whether the pressure parameter recovers to be smaller than the second threshold value after the battery enters into the sleep state; and

the recovery generation unit is configured to generate a sleep recover instruction for triggering the battery to recover from the sleep state to a normal operating state, if the detected result is that the pressure parameter is smaller than the second threshold value.

According to a fourth aspect of embodiments of the present disclosure, there is provided an electronic device, including:
one or more processors;
a memory; and
one or more program modules stored in the memory and being configured to be executed by the one or more processors, the one or more program modules causing the one or more processors to execute the steps of the method according to the second aspect of embodiments of the present disclosure and having the following functions:
acquiring a pressure parameter on a surface of a battery;
detecting a magnitude relation between the pressure parameter and a predefined threshold value; and
generating a control instruction for protecting the battery based on the detected result.

According to a fifth aspect of embodiments of the present disclosure, there is provided a program product having stored therein instructions that, when executed by one or more processors of an electronic device, cause the electronic device to perform the steps of the method according to the second aspect of embodiments of the present disclosure.

The technical solutions provided by the embodiments of the present disclosure may include the following advantageous effects.

The present disclosure samples the pressure parameter on the surface of the battery by the pressure sensor, detects the magnitude relation between the pressure parameter and the predefined threshold value and generates the control instruction for protecting the battery based on the detected result by the controller, thereby solving the safety hazard existing when the battery is impacted or is extruded which is not solved by the related art, achieving the effect of eliminating the safety hazard existing when the battery is impacted or is extruded, and protecting the battery and the electronic apparatus more comprehensively.

It is to be understood that both the foregoing general description and the following detailed description are exemplary and explanatory only and are not restrictive of the invention, as claimed.

### BRIEF DESCRIPTION OF THE DRAWINGS

In order to explain the embodiments of the present disclosure more clearly, the brief introduction of the drawings used for describing the embodiments will be given below. It is apparent that the accompanying drawings only illustrate some embodiments of the present disclosure, and other drawings may be obtained by the person skilled in the art according to these drawings without inventive labor.
Fig. 1 is an exemplary structural diagram of an electronic apparatus according to an exemplary embodiment;
Fig. 2A is an exemplary structural diagram of another electronic apparatus according to an exemplary embodiment;
Fig. 2B is an exemplary diagram of a reminder alert in one embodiment according to an exemplary embodiment;
Fig. 3 is an exemplary method flow chart of the battery protection method provided by one embodiment according to an exemplary embodiment;
Fig. 4 is an exemplary method flow chart of the battery protection method provided by one embodiment according to an exemplary embodiment;
Fig. 5 is an exemplary structural block diagram of the battery protection device provided by one embodiment according to an exemplary embodiment;
Fig. 6 is an exemplary structural block diagram of the battery protection device provided by another embodiment according to an exemplary embodiment; and
Fig. 7 is an exemplary structural diagram of the electronic apparatus involved in respective embodiments according to an exemplary embodiment.

Specific embodiments in this disclosure have been shown by way of example in the foregoing drawings and are hereinafter described in detail. The figures and written description are not intended to limit the scope of the inventive concepts in any manner. Rather, they are provided to illustrate the inventive concepts to a person skilled in the art by referring to particular embodiments.

### DETAILED DESCRIPTION

In order to make the purposes, the technical solutions and the advantages of the present disclosure more apparent, the present disclosure will be further described in detail with reference to the accompanying drawings. It is apparent that the described embodiments are only a part of embodiments of the present disclosure, but not all the embodiments. Based on the embodiments of the present disclosure, all the other embodiments obtained by the person skilled in the art without inventive labor should fall within the protection scope of the present disclosure.

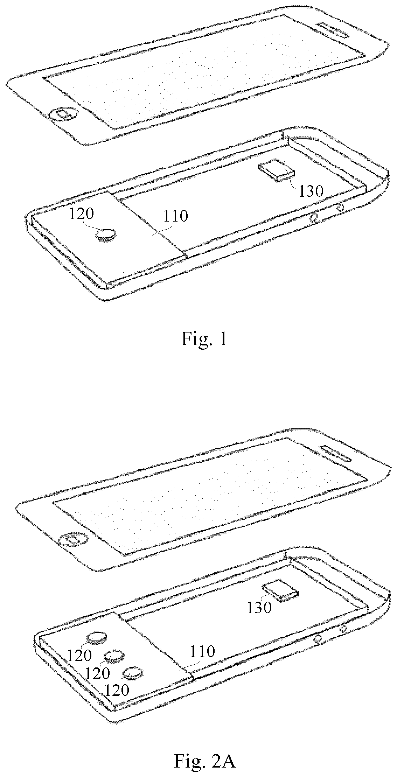

Referring to Fig. 1, which illustrates an exemplary structural diagram of an electronic apparatus provided by one embodiment of the present disclosure, the electronic apparatus may include: a battery 110, at least one pressure sensor 120 provided on a surface of the battery, and a controller 130 electrically connected with the pressure sensor 120. In the present embodiment, the electronic apparatus including one pressure sensor 120 is explained as an example.

The pressure sensor 120 samples a pressure parameter on the surface of the battery.

The controller 130 acquires the pressure parameter on the surface of the battery, detects a magnitude relation between the pressure parameter and a predefined threshold value, and generates a control instruction for protecting the battery 110 based on the detected result.

From above, the electronic apparatus provided by the present embodiment samples the pressure parameter on the surface of the battery by the pressure sensor, detects the magnitude relation between the pressure parameter and the predefined threshold value and generates the control instruction for protecting the battery based on the detected result by the controller, thereby solving the safety hazard existing when the battery is impacted or is extruded which is not solved by the related art, achieving the effect of eliminating the safety hazard existing when the battery is impacted or is extruded, and protecting the battery and the electronic apparatus more comprehensively.

Referring to Fig. 2A, which illustrates an exemplary structural diagram of an electronic apparatus provided by another embodiment of the present disclosure, the electronic apparatus may include: a battery 110, at least one pressure sensor 120 provided on a surface of the battery, and a controller 130 electrically connected with the pressure sensor 120. In the present embodiment, the electronic apparatus including three pressure sensors 120 is explained as an example.

The three pressure sensors 120 are provided uniformly at different positions on the surface of the battery 110, and the predefined threshold values to which the pressure sensors 120 at different positions respectively correspond are the same or different.

Each of the pressure sensors 120 may be provided at an outer surface of the battery 110 adjacent to a side of a housing of the electronic apparatus, or may be provided at an inner surface of the battery 110 adjacent to a side of a battery cell inside the battery 110. As shown in Fig. 2A, in the present embodiment, three pressure sensors 120 provided uniformly at the outer surface of the battery 110 adjacent to the side of the housing of the electronic apparatus are described as an example. In actual applications, the number and positions of the pressure sensors 120 may be determined according to actual requirements, and there is no specific limitation thereto.

In addition, the predefined threshold values to which the pressure sensors 120 at different positions respectively correspond are the same or different. The predefined threshold value, to which a certain pressure sensor 120 corresponds, indicates a pressure value to be compared with the pressure parameter on the surface of the battery sampled by the pressure sensor 120. In the present embodiment, the three pressure sensors 120 at different positions respectively corresponding to different predefined threshold values are described as an example, i.e., the three pressure sensors 120 respectively correspond to a first threshold value, a second threshold value, and a third threshold value which increase progressively.

Each of the pressure sensors 120 samples the pressure parameter on the surface of the battery.

The pressure sensors 120 record the pressure parameters on the surface of the battery in real time. The pressure sensors 120 record both an external pressure force exerted on the battery 110 and a pressure action produced by an expansion of the battery due to an interior chemical reaction inside the battery 110.

The controller 130 acquires the pressure parameters on the surface of the battery.

The controller 130 is electrically connected with each pressure sensor 120 to acquire the pressure parameters on the surface of the battery sampled by the pressure sensors 120.

The controller 130 further detects a magnitude relation between the pressure parameters and the predefined threshold values.

In the present embodiment, three predefined threshold values are preset, which are respectively the first threshold value, the second threshold value, and the third threshold value which increase progressively. The controller 130 detects, at a predetermined time interval, the magnitude relations between the pressure parameter and the first threshold value, the second threshold value, and the third threshold value which increase progressively.

For example, in the present embodiment, the predefined threshold values to which the three pressure sensors 120 located at different positions respectively correspond are different, and are respectively the first threshold value, the second threshold value, and the third threshold value which increase progressively. Thus, the controller 130 detects the magnitude relation between the first pressure sensor 120 and the first threshold value at the predetermined time interval, detects the magnitude relation between the second pressure sensor 120 and the second threshold value at the predetermined time interval, and detects the magnitude relation between the third pressure sensor 120 and the third threshold value at the predetermined time interval, wherein it is assumed that the first threshold value is 20 Newton (N), the second threshold value is 50 N, and the third threshold value is 100 N.

The controller 130 further generates a control instruction for protecting the battery 110 based on the detected result.

In particular, in a first possible implementation manner, if the detected result is that the pressure parameter is larger than the first threshold value and smaller than the second threshold value, the controller 130 generates a reminder information displaying instruction.

The reminder information displaying instruction is used to trigger the electronic apparatus to issue a reminder alert via a display screen, a speaker and/or a signal lamp. For example, when the battery 110 is being charged by the user, if the pressure parameter sampled by the first pressure sensor 120, which is detected by the controller 130, is larger than the first threshold value 20 N and smaller than the second threshold value 50 N due to the expansion inside the battery, the reminder information displaying instruction is generated. For instance, the reminder alert may be directly issued by the speaker, or may be issued by displaying information on the display screen, or the like.

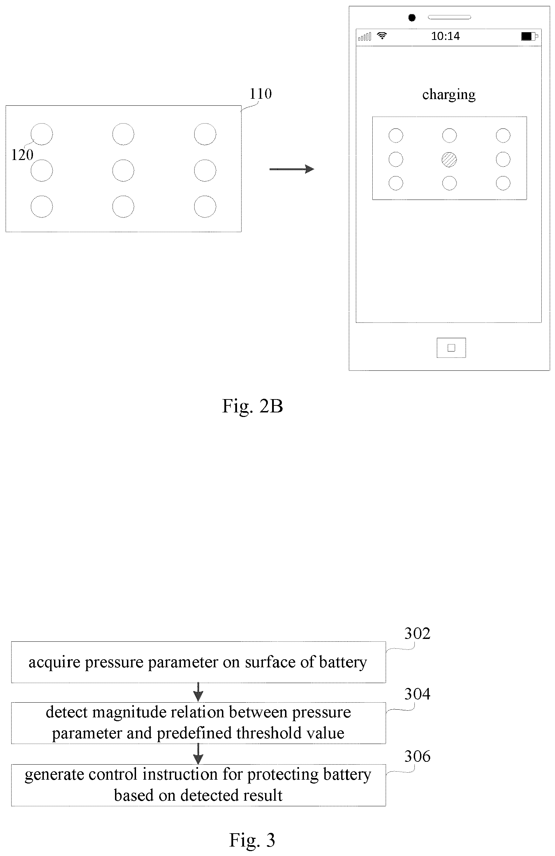

As shown in Fig. 2B, assuming that nine pressure sensors 120 are uniformly provided on the surface of the battery 110, when the battery 110 is being charged, nine blocks on the display screen of the electronic apparatus respectively indicate the pressure parameters sampled by respective pressure sensors 120. In a normal state, i.e., when the pressure parameter sampled by the pressure sensor 120 is smaller than 20 N, the block is displayed in green (not shown in the drawing). If the pressure parameter sampled by the pressure sensor 120 in the middle position at a certain time point exceeds the first threshold value 20 N and smaller than the second threshold value 50 N, the block in the middle position of the display screen changes from green to red (which is indicated by the oblique lines in the drawing). Thereby, the reminder alert is issued to the user.

In a second possible implementation manner, if the detected result is that the pressure parameter is larger than the second threshold value and smaller than the third threshold value, a sleep instruction is generated.

The sleep instruction is used to trigger the battery 110 to enter into a sleep state. The battery 110 entering into the sleep state is mainly controlled by controlling a battery chip inside the battery to stop working. When the pressure parameter on the surface of the battery increases continually, if the pressure parameter sampled by the second pressure sensor 120, which is detected by the controller 130, is larger than the second threshold value 50 N and smaller than the third threshold value 100 N, the sleep instruction is generated to trigger the battery 110 to enter into the sleep state.

In a third possible implementation manner, if the detected result is that the pressure parameter is larger than the third threshold value, a permanent failure instruction is generated.

The permanent failure instruction is used to trigger the battery 110 to enter into a permanent failure state. When the pressure parameter on the surface of the battery increases continually, if the pressure parameter sampled by the third pressure sensor 120, which is detected by the controller 130, is larger than the third threshold value 100 N, the permanent failure instruction is generated to trigger the battery 110 to enter into the permanent failure state.

In addition, after the battery 110 enters into the sleep state, the controller 130 further detects whether the pressure parameter recovers to be smaller than the second threshold value; and if the detected result is that the pressure parameter is smaller than the second threshold value, a sleep recover instruction, which is used to trigger the battery 110 to recover from the sleep state to the normal operating state, is generated. If the pressure parameter on the surface of the battery does not increase continually, but reduces to be smaller than 50 N after the battery 110 enters into the sleep state, the sleep recover instruction is generated. For instance, an excitation voltage or an excitation current may be applied to the battery 110, so as to trigger the battery 110 to recover from the sleep state to the normal operating state.

In the above three implementation manners, the safety levels for protecting the battery 110 increase progressively. For the same battery 110, one of the first threshold value, the second threshold value and the third threshold value may be set, or two or all three of the first threshold value, the second threshold value and the third threshold value may be set. The present disclosure is not limited thereto.

From above, the electronic apparatus provided by the present embodiment samples the pressure parameters on the surface of the battery by the pressure sensors, detects the magnitude relations between the pressure parameters and the predefined threshold values and generates the control instruction for protecting the battery based on the detected result by the controller, thereby solving the safety hazard existing when the battery is impacted or is extruded which is not solved by the related art, achieving the effect of eliminating the safety hazard existing when the battery is impacted or is extruded, and protecting the battery and the electronic apparatus more comprehensively.

The electronic apparatus provided by the present embodiment further detects the magnitude relations between the pressure parameters and different predefined threshold values to generate three different control instructions by the controller, thereby providing the battery and the electronic apparatus with a protection having different safety levels.

Referring to Fig. 3, which illustrates an exemplary method flow chart of the battery protection method provided by one embodiment of the present disclosure, the battery protection method is applied in the controller shown in Fig. 1 or Fig. 2A. The battery protection method may include the following steps.

In step 302, a pressure parameter on a surface of a battery is acquired.

In step 304, a magnitude relation between the pressure parameter and a predefined threshold value is detected.

In step 306, a control instruction for protecting the battery is generated based on the detected result.

From above, the battery protection method provided by the present embodiment acquires the pressure parameter on the surface of the battery, detects the magnitude relation between the pressure parameter and the predefined threshold value, and generates the control instruction for protecting the battery based on the detected result, thereby solving the safety hazard existing when the battery is impacted or is extruded which is not solved by the related art, achieving the effect of eliminating the safety hazard existing when the battery is impacted or is extruded, and protecting the battery and the electronic apparatus more comprehensively.

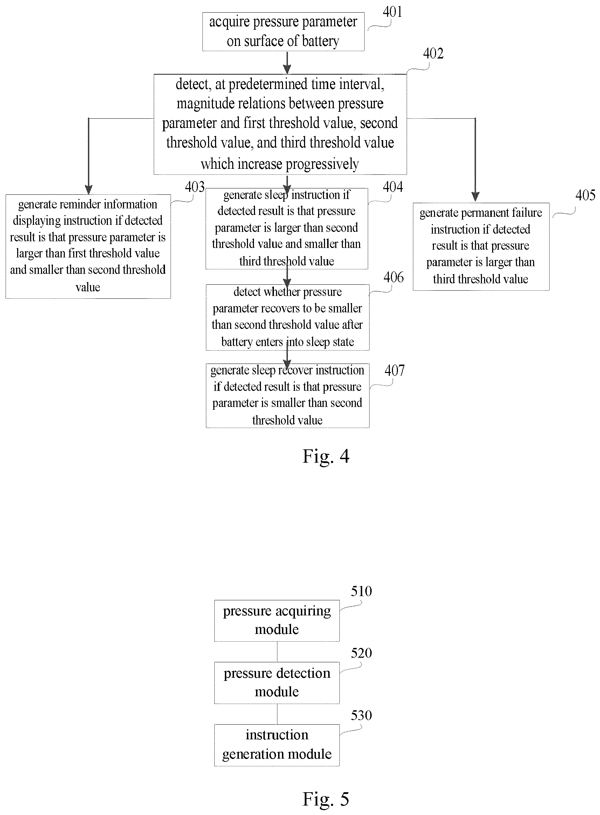

Referring to Fig. 4, which illustrates an exemplary method flow chart of the battery protection method provided by another embodiment of the present disclosure, the battery protection method is applied in the controller shown in Fig. 1 or Fig. 2A. The battery protection method may include the following steps.

In step 401, a pressure parameter on a surface of a battery is acquired.

The pressure parameter on the surface of the battery is sampled by installing at least one pressure sensor on the surface of the battery, and the controller is electrically connected with the at least one pressure sensor so as to acquire the pressure parameter on the surface of the battery sampled by the pressure sensor.

In step 402, the magnitude relations between the pressure parameter and a first threshold value, a second threshold value, and a third threshold value which increase progressively are detected at a predetermined time interval.

The three predefined threshold values are set in advance, and are respectively the first threshold value, the second threshold value, and the third threshold value which increase progressively. The controller detects, at the predetermined time interval, the magnitude relations between the pressure parameter and the first threshold value, the second threshold value, and the third threshold value which increase progressively. In the present embodiment, it is assumed that the first threshold value may be 20 N, the second threshold value may be 50 N, and the third threshold value may be 100 N.

In step 403, if the detected result is that the pressure parameter is larger than the first threshold value and smaller than the second threshold value, a reminder information displaying instruction is generated.

The reminder information displaying instruction is used to trigger the electronic apparatus to issue a reminder alert via a display screen, a speaker and/or a signal lamp. For example, when the battery is being charged by the user, if the pressure parameter detected by the controller is larger than the first threshold value 20 N and smaller than the second threshold value 50 N due to an expansion inside the battery, the reminder information displaying instruction is generated. For instance, the reminder alert may be directly issued by the speaker, or may be issued by displaying information on the display screen, or the like.

In step 404, if the detected result is that the pressure parameter is larger than the second threshold value and smaller than the third threshold value, a sleep instruction is generated.

The sleep instruction is used to trigger the battery to enter into a sleep state. The battery entering into the sleep state is mainly controlled by controlling a battery chip inside the battery to stop working. When the pressure parameter on the surface of the battery increases continually, if the pressure parameter detected by the controller is larger than the second threshold value 50 N and smaller than the third threshold value 100 N, the sleep instruction is generated to trigger the battery to enter into the sleep state.

In step 405, if the detected result is that the pressure parameter is larger than the third threshold value, a permanent failure instruction is generated.

The permanent failure instruction is used to trigger the battery to enter into a permanent failure state. When the pressure parameter on the surface of the battery increases continually, if the pressure parameter detected by the controller is larger than the third threshold value 100 N, the permanent failure instruction is generated to trigger the battery to enter into the permanent failure state.

In addition, after the above step 404, the method further includes the following steps.

In step 406, after the battery enters into the sleep state, whether the pressure parameter recovers to be smaller than the second threshold value is detected.

After the battery enters into the sleep state, the controller detects whether the pressure parameter recovers to be smaller than the second threshold value.

In step 407, if the detected result is that the pressure parameter is smaller than the second threshold value, a sleep recover instruction is generated.

The sleep recover instruction is used to trigger the battery to recover from the sleep state to the normal operating state. If the pressure parameter on the surface of the battery does not increase continually, but reduces to be smaller than 50 N after the battery enters into the sleep state, the sleep recover instruction is generated. For instance, an excitation voltage or an excitation current may be applied to the battery, so as to trigger the battery to recover from the sleep state to the normal operating state.

It should be explained that in actual applications, for the same battery, one of the first threshold value, the second threshold value and the third threshold value may be set, or two or all three of the first threshold value, the second threshold value and the third threshold value may be set. The present disclosure is not limited thereto.

From above, the battery protection method provided by the present embodiment acquires the pressure parameter on the surface of the battery, detects the magnitude relation between the pressure parameter and the predefined threshold value, and generates the control instruction for protecting the battery based on the detected result, thereby solving the safety hazard existing when the battery is impacted or is extruded which is not solved by the related art, achieving the effect of eliminating the safety hazard existing when the battery is impacted or is extruded, and protecting the battery and the electronic apparatus more comprehensively.

The battery protection method provided by the present embodiment further generates three different control instructions by detecting the magnitude relations between the pressure parameter and different predefined threshold values, thereby providing the battery and the electronic apparatus with a protection having different safety levels.

Hereinafter, the device embodiments of the present disclosure will be described, which may perform the method embodiments of the present disclosure. For the details which are not disclosed in the device embodiments of the present disclosure, the method embodiments of the present disclosure may be referred to.

Referring to Fig. 5, which illustrates an exemplary structural block diagram of the battery protection device provided by one embodiment of the disclosure, the battery protection device may constitute all or a part of the controller of the battery by software, hardware or a combination thereof. The battery protection device may include a pressure acquiring module 510, a pressure detection module 520, and an instruction generation module 530.

The pressure acquiring module 510 is configured to acquire a pressure parameter on a surface of the battery.

The pressure detection module 520 is configured to detect a magnitude relation between the pressure parameter and a predefined threshold value.

The instruction generation module 530 is configured to generate a control instruction for protecting the battery based on the detected result.

From above, the battery protection device provided by the present embodiment acquires the pressure parameter on the surface of the battery, detects the magnitude relation between the pressure parameter and the predefined threshold value, and generates the control instruction for protecting the battery based on the detected result, thereby solving the safety hazard existing when the battery is impacted or is extruded which is not solved by the related art, achieving the effect of eliminating the safety hazard existing when the battery is impacted or is extruded, and protecting the battery and the electronic apparatus more comprehensively.

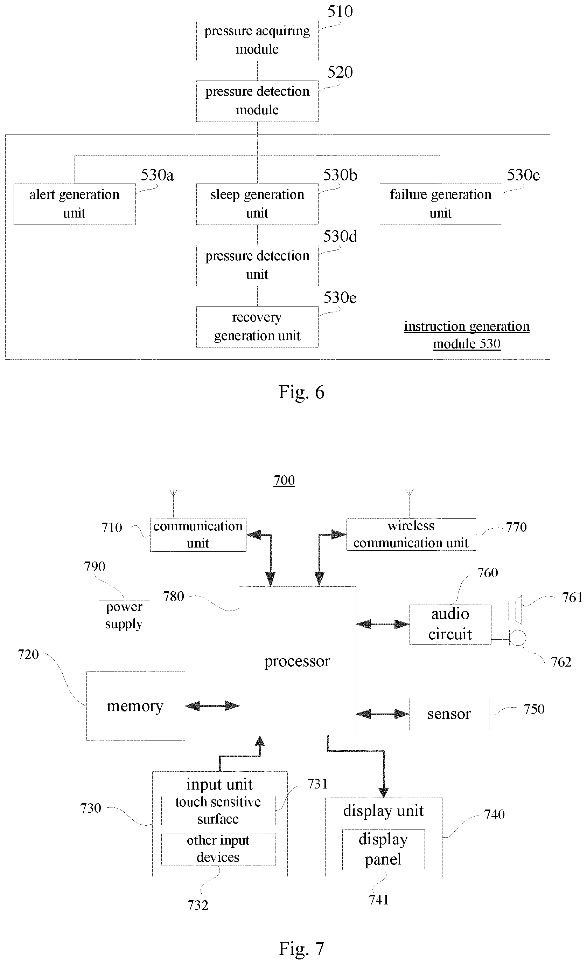

Referring to Fig. 6, which illustrates an exemplary structural block diagram of the battery protection device provided by another embodiment of the disclosure, the battery protection device may constitute all or a part of the controller of the battery by software, hardware or a combination thereof The battery protection device may include a pressure acquiring module 510, a pressure detection module 520, and an instruction generation module 530.

The pressure acquiring module 510 is configured to acquire a pressure parameter on a surface of the battery.

The pressure detection module 520 is configured to detect a magnitude relation between the pressure parameter and a predefined threshold value.

The pressure detection module 520 is further configured to detect, at a predetermined time interval, magnitude relations between the pressure parameter and a first threshold value, a second threshold value, and a third threshold value which increase progressively.

The instruction generation module 530 is configured to generate a control instruction for protecting the battery based on the detected result.

In particular, the instruction generation module 530 includes an alert generation unit 530a, a sleep generation unit 530b, and a failure generation unit 530c.

The alert generation unit 530a is configured to generate a reminder information displaying instruction if the detected result is that the pressure parameter is larger than the first threshold value and smaller than the second threshold value. The reminder information displaying instruction is used to trigger the electronic apparatus to issue a reminder alert via a display screen, a speaker and/or a signal lamp.

The sleep generation unit 530b is configured to generate a sleep instruction if the detected result is that the pressure parameter is larger than the second threshold value and smaller than the third threshold value. The sleep instruction is used to trigger the battery to enter into a sleep state.

The failure generation unit 530c is configured to generate a permanent failure instruction if the detected result is that the pressure parameter is larger than the third threshold value. The permanent failure instruction is used to trigger the battery to enter into a permanent failure state.

The instruction generation module 530 further includes a pressure detection unit 530d and a recovery generation unit 530e.

The pressure detection unit 530d is configured to detect whether the pressure parameter recovers to be smaller than the second threshold value after the battery enters into the sleep state.

The recovery generation unit 530e is configured to generate a sleep recover instruction if the detected result is that the pressure parameter is smaller than the second threshold value. The sleep recover instruction is used to trigger the battery to recover from the sleep state to the normal operating state.

From above, the battery protection device provided by the present embodiment acquires the pressure parameter on the surface of the battery, detects the magnitude relation between the pressure parameter and the predefined threshold value, and generates the control instruction for protecting the battery based on the detected result, thereby solving the safety hazard existing when the battery is impacted or is extruded which is not solved by the related art, achieving the effect of eliminating the safety hazard existing when the battery is impacted or is extruded, and protecting the battery and the electronic apparatus more comprehensively.

The battery protection device provided by the present embodiment further generates three different control instructions by detecting the magnitude relations between the pressure parameter and different predefined threshold values, thereby providing the battery and the electronic apparatus with a protection having different safety levels.

It should be explained that the battery protection devices provided by the above embodiments are only exemplified to be divided as the above respective functional modules when protecting the battery. In actual applications, the above functions may be distributed to be achieved by different functional modules according to requirements, i.e., the interior structure of the devices may be divided into different functional modules for achieving all or a part of the above described functions. In addition, the battery protection devices provided by the above embodiments and the method embodiments of the battery protection methods belong to the same concept, and the detailed implementing procedures of the battery protection devices may be referred to the method embodiments, which will not be repeated herein.

Another embodiment of the present disclosure provides an electronic device which may include: one or more processors; a memory; and one or more modules stored in the memory and being configured to be executed by the one or more processors, the one or more modules having the following functions: acquiring a pressure parameter on a surface of a battery; detecting a magnitude relation between the pressure parameter and a predefined threshold value; and generating a control instruction for protecting the battery based on the detected result.

Yet another embodiment of the present disclosure provides a program product having stored therein instructions that, when executed by one or more processors of an electronic device, cause the electronic device to perform: acquiring a pressure parameter on a surface of a battery; detecting a magnitude relation between the pressure parameter and a predefined threshold value; and generating a control instruction for protecting the battery based on the detected result.

Referring to Fig. 7, which illustrates an exemplary structural diagram of the electronic device involved in respective embodiments of the present disclosure, the electronic device may implement the battery protection methods provided by the above embodiments.

The electronic device 700 may include a communication unit 710, a memory 720 including one or more computer-readable storage mediums, an input unit 730, a display unit 740, a sensor 750, an audio circuit 760, a wireless communication unit 770, a processor 780 including one or more processing cores, a power supply 790 and the like. The person skilled in the art could appreciate that the structure of the electronic device shown in the drawing does not constitute the limitation to the electronic device, but may include more or less components than those shown in the drawing, or may combine some of the components, or may have different arrangement of the components.

The communication unit 710 is configured to receive and transmit signals during information receipt and transmission or during a call. The communication unit 710 may be a RF (radio frequency) circuit, a router, a modem, or other network communication device. Specifically, in the case that the communication unit 710 is the RF circuit, after receiving the downlink information from the base station, the one or more processors 780 processes the downlink information; additionally, the uplink data is transmitted to the base station. Generally, the RF circuit serving as the communication unit includes, but is not limited to an antenna, at least one amplifier, a tuner, one or more oscillators, a subscriber identity module (SIM) card, a transceiver, a coupler, a LNA (Low Noise Amplifier), a duplexer, etc. Additionally, the communication unit 710 may also communicate with network and other devices via wireless communication. The wireless communication may adopt any communication standards or protocols, including but not limited to GSM (Global System of Mobile communication), GPRS (General Packet Radio Service), CDMA (Code Division Multiple Access), WCDMA (Wideband Code Division Multiple Access), LTE (Long Term Evolution), E-mail, SMS (Short Messaging Service), etc. The memory 720 may be configured to store software programs and modules, and the processor 780 performs various functional applications and data processing by executing the software programs and modules stored in the memory 720. The memory 720 may mainly include a program storage region and a data storage region, wherein the program storage region may store an operation system, an application program required by at least one function (such as an audio playing function, an image playback function) and the like; and the data storage region may store the data created according to the usage of the electronic device 700 (such as audio data, a phone book) and the like. In addition, the memory 720 may include a high-speed random access memory, and may also include a non-transitory memory, such as at least one disc storage device, flash device or other transitory solid-state storage device. Accordingly, the memory 720 may also include a memory controller for providing the processor 780 and the input unit 730 with an access to the memory 720.

The input unit 730 may be configured to receive the input digits or character information, and generate signal inputs of a keyboard, a mouse, a joystick or a trackball related to the user settings and function control. Preferably, the input unit 730 may include a touch sensitive surface 731 and other input devices 732. The touch sensitive surface 731, which is also referred to as a touch screen or a touch pad, can collect the user's touch operation thereon or thereabout (for example, the user performs operations on the touch sensitive surface 731 or near the touch sensitive surface 731 by using fingers, a stylus, or any suitable object or accessory), and drive the corresponding connected device according to the preset program. Optionally, the touch sensitive surface 731 may include two parts, i.e., a touch detection device and a touch controller, wherein the touch detection device detects a touch orientation of the user and signals caused by the touch operation, and transmits the signals to the touch controller; and the touch controller receives the touch information from the touch detection device, converts the touch information into a contact coordinate and transmits it to the processor 780, and the touch controller can also receive the instruction from the processor 780 and execute the instruction. Additionally, the touch sensitive surface 731 may be achieved by adopting various types, such as a resistive type, a capacitive type, an infrared ray type, and a surface acoustic wave type. Besides the touch sensitive surface 731, the input unit 730 may also include other input device 732. Preferably, the other input device 732 may include but not limited to one or more of a physical keyboard, a function key (such as a volume control key, a switch key), a trackball, a mouse and a joystick.

The display unit 740 may be configured to display information input by the user or information provided to the user and various kinds of graphical user interfaces of the electronic device 700, and the graphical user interfaces may be constituted by a graphic, a text, an icon, a video and any combination thereof. The display unit 740 may include a display panel 741. Optionally, the display panel 741 may be configured in the form of a LCD (Liquid Crystal Display), an OLED (Organic Light-Emitting Diode) and the like. Further, the touch sensitive surface 731 may cover the display panel 741. When the touch operation on or near the touch sensitive surface 731 is detected, the touch sensitive surface 731 transmits the touch operation to the processor 780 to determine the type of the touch event, and then the processor 780 provides a corresponding visual output on the display panel 741 according to the type of the touch event. Although in Fig. 7, the touch sensitive surface 731 and the display panel 741 act as two independent components to achieve input and output functions, in some embodiments, the touch sensitive surface 731 and the display panel 741 may be integrated to achieve the input and output functions.

The electronic device 700 may further include at least one sensor 750 which is a pressure sensor for sampling the pressure parameter on the surface of the battery. In addition, the at least one sensor 750 may include a light sensor, a motion sensor, and other sensors. The light sensor may include an ambient light sensor and a proximity sensor, wherein the ambient light sensor may adjust the brightness of the display panel 741 according to the light and shade of the ambient light, and the proximity sensor may turn off the display panel 741 and/or the backlight when the electronic device 700 is moved to the ear. As one type of the motion sensors, the gravity acceleration sensor may detect the magnitude of the acceleration along respective directions (in general, three axes), may detect the magnitude and direction of the gravity when being stationary, and may identify the applications of the attitudes of the mobile phone (such as a horizontal and vertical screen switching, a relevant game, a magnetometer attitude calibration) and functions relevant to vibration identification (such as a pedometer, a percussion) and the like. The electronic device 700 may also be configured with a gyroscope, a barometer, a hygrometer, a thermometer, an infrared sensor and other sensors, which are not repeated herein.

The audio circuit 760, a speaker 761 and a microphone 762 may provide the audio interfaces between the user and the electronic device 700. The audio circuit 760 may transmit an electrical signal converted from the received audio data to the speaker 761, and the speaker 761 converts the electrical signal into an acoustical signal and outputs it. On the other hand, the microphone 762 converts the collected acoustical signal into an electrical signal, the audio circuit 760 receives the electrical signal, converts it into audio data, and outputs the audio data to the processor 780 for processing, then the processed audio data is for example transmitted to another electronic device via the RF circuit 710, or the audio data is output to the memory 720 for further processing. The audio circuit 760 may also include a receiver jack for providing the communication between the peripheral headphone and the electronic device 700.

In order to achieve the wireless communication, the wireless communication unit 770 may be provided on the electronic device. The wireless communication unit 770 may be a WIFI module. The WIFI belongs to the short-range wireless transmission technology. The electronic device 700 may assist the user to send and receive E-mails, browse the web, access the streaming media and the like via the wireless communication unit 770, and provide the user with the wireless broadband Internet access. Although the wireless communication unit 770 is shown in the drawing, it may be appreciated that the wireless communication unit 770 is not a necessary constitution of the electronic device 700, and can be omitted according to requirements without changing the essential scope of the invention.

The processor 780 is a control center of the electronic device 700. The processor 780 connects respective parts of the entire mobile phone via various interfaces and wirings, and performs various functions of the electronic device 700 and processes data so as to wholly monitor the mobile phone, by running or executing the software programs and/or modules within the memory 720 and calling the data stored in the memory 720. Optionally, the processor 780 may include one or more processing cores. Preferably, the processor 780 may integrate with the application processor and the modem processor, wherein the application processor mainly processes the operation system, the user interface, the application program, etc., and the modem processor mainly processes the wireless communication. It may be appreciated that the modem processor may not be integrated into the processor 780.

The electronic device 700 further includes a power supply 790 (such as a battery) for supplying power to respective components. Preferably, the power supply may be connected to the processor 780 logically via a power management system, so as to achieve the functions of a charge management, a discharge management and a power consumption management by the power management system. The power supply 790 may also include any components, such as one or more direct current or alternative current power supplies, recharging systems, power failure detection circuits, power converters or inverters, and power status indicators.

Although not shown in the drawing, the electronic device 700 may also include a camera, a Bluetooth module, and the like, which are not repeated herein. In the present embodiment, the electronic device further includes a memory and one or more programs stored in the memory. The one or more processors executing the one or more programs include performing the instructions in the controller of the electronic device involved in the battery protection method provided by the embodiment shown in Fig. 3 or Fig. 4 of the present disclosure.

In addition, typically, the electronic device described in the present disclosure may be various handheld terminals, such as a mobile phone, and a personal digital assistant (PDA). Thereby, the protection scope of the present disclosure should not be restricted to any specific type of the electronic device.

Additionally, the method according to the present disclosure may be implemented as the computer program executed by CPU, and the computer program may be stored in the computer-readable storage medium. When the computer program is executed by the CPU, the above functions defined in the method of the present disclosure are performed.

Furthermore, the above steps in the method and the units in the system may also be realized by using the controller and the computer-readable storage medium which stores the computer program for causing the controller to achieve the above steps or unit functions.

Moreover, it should be understood that the computer-readable storage medium (such as the memory) described in the present disclosure may be a transitory or non-transitory memory, or a combination thereof. As an example and not restrictive, the non-transitory memory may include a read-only memory (ROM), a programmable ROM (PROM), an electrically programmable ROM (EPROM), an electrically erasable programmable ROM (EEPROM), or a flash memory. The transitory memory may include a random access memory (RAM) which can act as an external cache memory. As an example and not restrictive, RAM may be obtained in various forms, such as a synchronous RAM (DRAM), a dynamic RAM (DRAM), a synchronous DRAM (SDRAM), a double data rate SDRAM (DDR SDRAM), an enhanced SDRAM (ESDRAM), a synchronization link DRAM (SLDRAM), and a direct RambusRAM (DRRAM). The storage devices in the aspects of the present disclosure are intended to include, but not limited to, these and any other suitable types of memory.

The person skilled in the art should also understand that the various illustrative logical blocks, modules, circuits and algorithm steps described in combination with the contents disclosed herein may be implemented as an electronic hardware, computer software or a combination thereof. In order to clearly explain the interchangeability between the hardware and the software, a general description has been given in terms of the functions of various illustrative components, blocks, modules, circuits and steps. These functions are implemented as the software or implemented as the hardware depending on the particular applications and the design constraints imposed to the whole system. The person skilled in the art may realize these functions in various manners with respect to each kind of particular application, but this realization should not be interpreted as departing from the scope of the present disclosure.

The various illustrative logical blocks, modules and circuits described in combination with the contents disclosed herein may be realized or executed by the following components which are designed for executing the above functions: a general purpose processor, a digital signal processor (DSP), an application specific IC (ASIC), a field programmable gate array (FPGA), or other programmable logic devices, a discrete gate, or a transistor logic, a discrete hardware element or any combination thereof. The general purpose processor may be a microprocessor. Alternatively, the processor may be any conventional processor, controller, microcontroller or state machine. The processor may also be implemented as a combination of the computing devices, such as a combination of a DSP and a microprocessor, a plurality of microprocessors, one or more microprocessor combined with a DSP core, or any other such configurations.

The steps of the method or algorithm described in combination with the contents disclosed herein may be directly included in the hardware, in the software module executed by the processor, or in a combination thereof. The software module may reside in a RAM, a flash memory, a ROM, an EPROM, an EEPROM, a register, a hard disk, a removable disk, a CD-ROM, or any other storage mediums of any forms known in the art. The exemplary storage medium is coupled to the processor such that the processor can read information from the storage medium or write information into the storage medium. In an alternative solution, the storage medium may be integrated to the processor. The processor and the storage medium may reside in an ASIC. The ASIC may reside in a user terminal. In an alternative solution, the processor and the storage medium may reside in the user terminal as discrete components.

In one or more exemplary designs, the functions may be implemented in hardware, software, firmware, or any combination thereof. If the functions are implemented in software, the functions may be stored in the computer-readable storage medium or may be transmitted by the computer-readable medium as one or more instructions or codes. The computer-readable medium includes a computer storage medium and a communication medium, and the communication medium includes any medium assisting the transmission of the computer program from one place to another place. The storage medium may be any available medium which is able to be accessed by a general purpose or special purpose computer. As an example and not restrictive, the computer-readable medium may include a RAM, a ROM, an EEPROM, a CD-ROM or other optical disc storage devices, magnetic disc storage devices or other magnetic storage devices, or may be any other media which are used to carry or store the desired program codes in the form of instructions or data structures and can be accessed by a general purpose or special purpose computer or a general purpose or special purpose processor. Also, any linking may be properly referred to as the computer-readable medium. For example, if sending the software from a website, a server, or other remote sources by a coaxial cable, a fiber optic cable, a twisted pair, a digital subscriber line (DSL), or a wireless technology such as an infrared, a radio and a microwave technologies, the above coaxial cable, fiber optic cable, twisted pair, DSL, or wireless technology such as the infrared, the radio and the microwave technologies are included in the definition of the media. As used herein, the magnetic disc and the optical disc include a compact disc (CD), a laser disc, an optical disc, a digital versatile disc (DVD), a floppy disc and a blu-ray disc, wherein the magnetic disc usually reproduces data magnetically, while the optical disc reproduces data optically with lasers. The combinations of the above contents should also be included within the scope of the computer-readable medium.

Although the exemplary embodiments of the present disclosure are illustrated in the above contents, it should be noted that various changes and modifications may be made to the disclosed exemplary embodiments without departing from the scope of the present disclosure as defined in the claims. The functions, steps and/or actions in the method claim according to the disclosed embodiments described herein need not be performed in any specific order. In addition, although the elements of the present disclosure may be described or claimed in the individual form, they can also be conceived to be more unless they are explicitly restricted to be singular.

It should be understood that in the present disclosure, unless the exceptional case in which the context clearly gives supports, the singular forms "a", "an", and "the" are intended to include the plural forms. It should also be appreciated that the expression "and/or" used herein indicates including any and all possible combinations of one or more of the associated listed items.

The serial numbers of the aforementioned embodiments in the present disclosure are only for illustrative purpose, not showing the superiority or inferiority of the embodiments.

The person skilled in the art can understand that the whole or part of the steps for achieving the above-described embodiments can be accomplished by hardware, or be accomplished by a program instructing relevant hardware, the program may be stored in a computer readable storage medium, and the above-mentioned storage medium may be a read-only memory, a magnetic disc or an optical disc.

## Claims

1. A portable electronic apparatus, **characterized in that**, the electronic apparatus comprises: a battery (110), at least one pressure sensor (120) provided on a surface of the battery, and a controller (130) electrically connected with the pressure sensor;
whereas the pressure sensor samples a pressure parameter on the surface of the battery; the controller acquires the pressure parameter on the surface of the battery, detects a magnitude relation between the pressure parameter and a predefined threshold value, and generates a control instruction for protecting the battery based on the detected result; the controller is configured to detect, at a predetermined time interval, the magnitude relations between the pressure parameter and a first threshold value, a second threshold value, and a third threshold value which increase progressively; and
the controller is further configured to generate a reminder information instruction for triggering the electronic apparatus to issue a reminder alert via a display screen, a speaker and/or a signal lamp, if the detected result is that the pressure parameter is larger than the first threshold value and smaller than the second threshold value; and generates a permanent failure instruction for triggering the battery to enter into a permanent failure state, if the detected result is that the pressure parameter is larger than a third threshold value; **characterized in that** the controller is configured to generate sleep instruction for triggering the battery to enter into a sleep state, if the detected result is that the pressure parameter is larger than the second threshold value and smaller than the third threshold value; and
the controller is configured to detect whether the pressure parameter recovers to be smaller than the second threshold value after the battery enters into the sleep state, and to generate a sleep recover instruction for triggering the battery to recover from the sleep state to a normal operating state if the detected result is that the pressure parameter is smaller than the second threshold value.

2. The portable electronic apparatus according to claim 1, **characterized in that**, the a plurality of pressure sensors (120) are provided uniformly at different positions on the surface of the battery, and the predefined threshold values to which the pressure sensors at different positions respectively correspond are the same or different.

3. A battery protection method for portable electronic apparatus, **characterized in that**, the battery protection method is used in a controller, and the method comprises:
acquiring a pressure parameter on a surface of a battery;
detecting a magnitude relation between the pressure parameter and a predefined threshold value; and
generating a control instruction for protecting the battery based on the detected result wherein the steps of "detecting a magnitude relation between the pressure parameter and a predefined threshold value; and, generating a control instruction for protecting the battery based on the detected result comprise:
detecting, at a predetermined time interval, the magnitude relations between the pressure parameter and a first threshold value, a second threshold value, and a third threshold value which increase progressively;
generating a reminder information displaying instruction for triggering an electronic apparatus to issue a reminder alert via a display screen, a speaker and/or a signal lamp, if the detected result is that the pressure parameter is larger than the first threshold value and smaller than the second threshold value;
generating a permanent failure instruction for triggering the battery to enter into a permanent failure state, if the detected result is that the pressure parameter is larger than a third threshold value; **characterized by** generating a sleep instruction for triggering the battery to enter into a sleep state, if the detected result is that the pressure parameter is larger than the second threshold value and smaller than the third threshold value; and
detecting whether the pressure parameter recovers to be smaller than the second threshold value after the battery enters into the sleep state; and
generating a sleep recover instruction for triggering the battery to recover from the sleep state to a normal operating state if the detected result is that the pressure parameter is smaller than the second threshold value.

4. A battery protection device for portable electronic apparatus, **characterized in that**, the battery protection device is used in a controller, and the device comprises:
a pressure acquiring module (510) configured to acquire a pressure parameter on a surface of a battery;
a pressure detection module (520) configured to detect a magnitude relation between the pressure parameter and a predefined threshold value; and
an instruction generation module (530) configured to generate a control instruction for protecting the battery based on the detected result; wherein
the pressure detection module is further configured to detect, at a predetermined time interval, the magnitude relations between the pressure parameter and a first threshold value, a second threshold value, and a third threshold value which increase progressively;
the instruction generation module comprises an alert generation unit, a sleep generation unit, and a failure generation unit;
the alert generation unit (530a) is configured to generate a reminder information displaying instruction for triggering an electronic apparatus to issue a reminder alert via a display screen, a speaker and/or a signal lamp, if the detected result is that the pressure parameter is larger than the first threshold value and smaller than the second threshold value;
the failure generation unit (530c) is configured to generate a permanent failure instruction for triggering the battery to enter into a permanent failure state, if the detected result is that the pressure parameter is larger than the third threshold value; **characterized in that** the sleep generation unit (530b) is configured to generate a sleep instruction for triggering the battery to enter into a sleep state, if the detected result is that the pressure parameter is larger than the second threshold value and smaller than the third threshold value;
the instruction generation module further comprises a pressure detection unit and a recovery generation unit;
the pressure detection unit is configured to detect whether the pressure parameter recovers to be smaller than the second threshold value after the battery enters into the sleep state; and
the recovery generation unit is configured to generate a sleep recover instruction for triggering the battery to recover from the sleep state to a normal operating state, if the detected result is that the pressure parameter is smaller than the second threshold value.

5. A portable electronic device, **characterized in that**, the electronic device comprises:
one or more processors;
a memory; and
one or more program modules stored in the memory and being configured to be executed by the one or more processors, the one or more program modules causing the one or more processors to execute the steps of claim 3.

6. A program product having stored therein instructions that, when executed by one or more processors of a portable electronic device, cause the electronic device to perform the steps of claim 3.

## Patentansprüche

1. Tragbare elektronische Vorrichtung, **dadurch gekennzeichnet, dass** die elektronische Vorrichtung Folgendes umfasst: eine Batterie (110), wenigstens einen auf einer Oberfläche der Batterie vorgesehenen Drucksensor (120) und einen elektrisch mit dem Drucksensor verbundenen Controller (130); wobei
der Drucksensor einen Druckparameter auf der Oberfläche der Batterie abtastet;
der Controller den Druckparameter auf der Oberfläche der Batterie erfasst, eine Größenbeziehung zwischen dem Druckparameter und einem vordefinierten Schwellenwert erkennt und eine Steuerinstruktion zum Schützen der Batterie auf der Basis des erkannten Ergebnisses erzeugt; der Controller konfiguriert ist zum Erkennen, in einem vorbestimmten Zeitintervall, der Größenbeziehungen zwischen dem Druckparameter und einem ersten Schwellenwert, einem zweiten Schwellenwert und einem dritten Schwellenwert, die progressiv zunehmen; und
der Controller ferner zum Erzeugen einer Erinnerungsinformationsinstruktion zum Veranlassen der elektronischen Vorrichtung zum Ausgeben eines Erinnerungsalarms über einen Anzeigeschirm, einen Lautsprecher und/oder eine Signallampe konfiguriert ist, wenn das erkannte Ergebnis das ist, dass der Druckparameter größer als der erste Schwellenwert und kleiner als der zweite Schwellenwert ist; und eine Dauerausfallinstruktion zum Veranlassen des Eintritts der Batterie in einen Dauerausfallzustand erzeugt, wenn das erkannte Ergebnis das ist, dass der Druckparameter größer als ein dritter Schwellenwert ist; **dadurch gekennzeichnet, dass** der Controller zum Erzeugen einer Ruheinstruktion zum Veranlassen des Eintritts der Batterie in einen Ruhezustand konfiguriert ist, wenn das erkannte Ergebnis das ist, dass der Druckparameter größer als der zweite Schwellenwert und kleiner als der dritte Schwellenwert ist; und
der Controller konfiguriert ist zum Erkennen, ob der Druckparameter zurückkehrt, so dass er kleiner als der zweite Schwellenwert ist, wenn die Batterie in den Ruhezustand eingetreten ist, und zum Erzeugen einer Ruherückkehrinstruktion zum Veranlassen der Rückkehr der Batterie vom Ruhezustand in einen normalen Betriebszustand, wenn das erkannte Ergebnis das ist, dass der Druckparameter kleiner als der zweite Schwellenwert ist.

2. Tragbare elektronische Vorrichtung nach Anspruch 1, **dadurch gekennzeichnet, dass** mehrere Drucksensoren (120) gleichmäßig an verschiedenen Positionen auf der Oberfläche der Batterie vorgesehen sind, und die vordefinierten Schwellenwerte, denen die Drucksensoren an verschiedenen Positionen jeweils entsprechen, gleich oder unterschiedlich sind.

3. Batterieschutzverfahren für eine tragbare elektronische Vorrichtung, **dadurch gekennzeichnet, dass** das Batterieschutzverfahren in einem Controller angewendet wird und das Verfahren Folgendes beinhaltet:
Erfassen eines Druckparameters auf einer Oberfläche einer Batterie;
Erkennen einer Größenbeziehung zwischen dem Druckparameter und einem vordefinierten Schwellenwert; und
Erzeugen einer Steuerinstruktion zum Schützen der Batterie auf der Basis des erkannten Ergebnisses, wobei die Schritte "Erkennen einer Größenbeziehung zwischen dem Druckparameter und einem vordefinierten Schwellenwert" und "Erzeugen einer Steuerinstruktion zum Schützen der Batterie auf der Basis des erkannten Ergebnisses" Folgendes beinhalten:
Erkennen, in einem vorbestimmten Zeitintervall, der Größenbeziehungen zwischen dem Druckparameter und einem ersten Schwellenwert, einem zweiten Schwellenwert und einem dritten Schwellenwert, die progressiv zunehmen;
Erzeugen einer Erinnerungsinformationsanzeige-Instruktion zum Veranlassen, dass eine elektronische Vorrichtung einen Erinnerungsalarm über einen Anzeigeschirm, einen Lautsprecher und/oder eine Signallampe ausgibt, wenn das erkannte Ergebnis das ist, dass der Druckparameter größer als der erste Schwellenwert und kleiner als der zweite Schwellenwert ist;
Erzeugen einer Dauerausfallinstruktion zum Veranlassen der Batterie, in einen Dauerausfallzustand einzutreten, wenn das erkannte Ergebnis das ist, dass der Druckparameter größer als ein dritter Schwellenwert ist; **gekennzeichnet durch** Erzeugen einer Ruheinstruktion zum Veranlassen der Batterie, in einen Ruhezustand einzutreten, wenn das erkannte Ergebnis das ist, dass der Druckparameter größer als der zweite Schwellenwert und kleiner als der dritte Schwellenwert ist; und
Erkennen, ob der Druckparameter zurückkehrt, so dass er kleiner als der zweite Schwellenwert ist, wenn die Batterie in den Ruhezustand eingetreten ist; und
Erzeugen einer Ruherückkehrinstruktion zum Veranlassen der Batterie, vom Ruhezustand in einen normalen Betriebszustand zurückzukehren, wenn das erkannte Ergebnis das ist, dass der Druckparameter kleiner als der zweite Schwellenwert ist.

4. Batterieschutzgerät für eine tragbare elektronische Vorrichtung, **dadurch gekennzeichnet, dass** das Batterieschutzgerät in einem Controller verwendet wird und das Gerät Folgendes umfasst:
ein Druckerfassungsmodul (510), konfiguriert zum Erfassen eines Druckparameters auf einer Oberfläche einer Batterie;
ein Druckerkennungsmodul (520), konfiguriert zum Erkennen einer Größenbeziehung zwischen dem Druckparameter und einem vordefinierten Schwellenwert; und
ein Instruktionserzeugungsmodul (530), konfiguriert zum Erzeugen einer Steuerinstruktion zum Schützen der Batterie auf der Basis der erkannten Ergebnisses; wobei
das Druckerkennungsmodul ferner so konfiguriert ist, dass es in einem vorbestimmten Zeitintervall die Größenbeziehungen zwischen dem Druckparameter und einem ersten Schwellenwert, einem zweiten Schwellenwert und einem dritten Schwellenwert erkennt, die progressiv zunehmen;
das Instruktionserzeugungsmodul eine Alarmerzeugungseinheit, eine Ruheerzeugungseinheit und eine Ausfallerzeugungseinheit umfasst;
die Alarmerzeugungseinheit (530a) konfiguriert ist zum Erzeugen einer Erinnerungsinformationsanzeige-Instruktion zum Veranlassen einer elektronischen Vorrichtung, einen Erinnerungsalarm über einen Anzeigeschirm, einen Lautsprecher und/oder eine Signallampe auszugeben, wenn das erkannte Ergebnis das ist, dass der Druckparameter größer als der erste Schwellenwert und kleiner als der zweite Schwellenwert ist;
die Ausfallerzeugungseinheit (530c) konfiguriert ist zum Erzeugen einer Dauerausfallinstruktion zum Veranlassen, dass die Batterie in einen Dauerausfallzustand eintritt, wenn das erkannte Ergebnis das ist, dass der Druckparameter größer als der dritte Schwellenwert ist; **dadurch gekennzeichnet, dass** die Ruheerzeugungseinheit (530b) konfiguriert ist zum Erzeugen einer Ruheinstruktion zum Veranlassen der Batterie, in einen Ruhezustand einzutreten, wenn das erkannte Ergebnis das ist, dass der Druckparameter größer als der zweite Schwellenwert und kleiner als der dritte Schwellenwert ist;
das Instruktionserzeugungsmodul ferner eine Druckerkennungseinheit und eine Rückkehrerzeugungseinheit umfasst;
die Druckerkennungseinheit konfiguriert ist zum Erkennen, ob der Druckparameter so zurückkehrt, dass er kleiner als der zweite Schwellenwert ist, wenn die Batterie in den Ruhezustand eintritt; und
die Rückkehrerzeugungseinheit konfiguriert ist zum Erzeugen einer Ruherückkehrinstruktion zum Veranlassen der der Batterie, vom Ruhezustand in einen normalen Betriebszustand zurückzukehren, wenn das erkannte Ergebnis das ist, dass der Druckparameter kleiner als der zweite Schwellenwert ist.

5. Tragbares elektronisches Gerät, **dadurch gekennzeichnet, dass** das elektronische Gerät Folgendes umfasst:
einen oder mehrere Prozessoren;
einen Speicher; und
ein oder mehrere Programmmodule, die im Speicher gespeichert und zum Ausführen durch die ein oder mehreren Prozessoren konfiguriert sind, wobei die ein oder mehreren Programmmodule bewirken, dass die ein oder mehreren Prozessoren die Schritte von Anspruch 3 ausführen.

6. Programmprodukt, auf dem Instruktionen gespeichert sind, die bei Ausführung durch einen oder mehrere Prozessoren eines tragbaren elektronischen Gerätes bewirken, dass das elektronische Gerät die Schritte von Anspruch 3 ausführt.

## Revendications

1. Appareil électronique portable, **caractérisé en ce que** l'appareil électronique comprend : une batterie (110), au moins un capteur de pression (120) fourni sur la surface de la batterie, et un contrôleur (130) connecté électriquement au capteur de pression ;
dans lequel le capteur de pression échantillonne un paramètre de pression sur la surface de la batterie ;
le contrôleur acquiert le paramètre de pression sur la surface de la batterie, détecte une relation de grandeur entre le paramètre de pression et une valeur limite prédéfinie, et génère une instruction de commande pour protéger la batterie en fonction du résultat détecté ; le contrôleur est configuré pour détecter, à un intervalle de temps indéterminé, les relations de grandeur entre le paramètre de pression et une première valeur limite, une deuxième valeur limite, et une troisième valeur limite qui augmentent progressivement ; et
le contrôleur est configuré en outre pour générer une instruction d'information de rappel pour déclencher l'appareil électronique afin d'émettre une alerte de rappel par l'intermédiaire d'un écran d'affichage, d'un haut-parleur et/ou d'une lampe de signalisation, si le résultat détecté est que le paramètre de pression est supérieur à la première valeur limite et inférieur à la deuxième valeur limite ; et génère une instruction de défaillance permanente pour déclencher la batterie afin qu'elle passe sur un état de défaillance permanent, si le résultat détecté est que le paramètre de pression est supérieur à une troisième valeur limite ; **caractérisé en ce que** le contrôleur est configuré pour générer une instruction de mise en veille pour déclencher la batterie afin qu'elle passe sur un état de veille, si le résultat détecté est que le paramètre de pression est supérieur à la deuxième valeur limite et inférieur à la troisième valeur limite ; et
le contrôleur est configuré pour détecter que le paramètre de pression redevient inférieur à la deuxième valeur limite après que la batterie passe dans l'état de veille, et générer une instruction de reprise après veille pour déclencher la batterie afin qu'elle revienne à un état fonctionnel normal après l'état de veille si le résultat détecté est que le paramètre de pression est inférieur à la deuxième valeur limite.

2. Appareil électronique portable selon la revendication 1, **caractérisé en ce qu'**une pluralité de capteurs de pression (120) est fournie uniformément à différentes positions sur la surface de la batterie, et les valeurs limites prédéfinies auxquelles les capteurs de pression à différentes positions correspondent respectivement sont identiques ou différentes.

3. Procédé de protection de batterie pour appareil électronique portable, **caractérisé en ce que** le procédé de protection de batterie est utilisé dans un contrôleur, et le procédé comprend :
l'acquisition d'un paramètre de pression sur une surface d'une batterie ;
la détection d'une relation de grandeur entre le paramètre de pression et une valeur limite prédéfinie ; et
la génération d'une instruction de commande pour protéger la batterie en fonction du résultat détecté dans lequel les étapes de détection d'une relation de grandeur entre le paramètre de pression et une valeur limite prédéfinie ; et de génération d'une instruction de commande pour protéger la batterie en fonction du résultat détecté comprennent :
la détection, à un intervalle de temps prédéterminé, des relations de grandeur entre le paramètre de pression et une première valeur limite, une deuxième valeur limite et une troisième valeur limite qui augmentent progressivement ;
la génération d'une instruction d'affichage d'une information de rappel pour déclencher un appareil électronique afin qu'il émette une alerte de rappel par l'intermédiaire d'un écran d'affichage, d'un haut-parleur et/ou d'une lampe de signalisation, si le résultat détecté est que le paramètre de pression est supérieur à la première valeur limite et inférieur à la deuxième valeur limite ;
la génération d'une instruction de défaillance permanente pour déclencher la batterie afin qu'elle passe sur un état de défaillance permanent, si le résultat détecté est que le paramètre de pression est supérieur à une troisième valeur limite ; **caractérisé par** la génération d'une instruction de mise en veille pour déclencher la batterie afin qu'elle passe sur un état de veille, si le résultat détecté est que le paramètre de pression est supérieur à la deuxième valeur limite et inférieur à la troisième valeur limite ; et
la détection que le paramètre de pression redevient inférieur à la deuxième valeur limite après que la batterie passe dans l'état de veille ; et
la génération d'une instruction de reprise après veille pour déclencher la batterie afin qu'elle revienne à un état fonctionnel normal après l'état de veille si le résultat détecté est que le paramètre de pression est inférieur à la deuxième valeur limite.

4. Dispositif électronique portable pour appareil électronique portable, **caractérisé en ce que** le dispositif de protection de batterie est utilisé dans un contrôleur, et le dispositif comprend :
un module d'acquisition de pression (510) configuré pour acquérir un paramètre de pression sur une surface d'une batterie ;
un module de détection de pression (520) configuré pour détecter une relation de grandeur entre le paramètre de pression et une valeur limite prédéfinie ; et
un module de génération d'instruction (530) configuré pour générer une instruction de commande pour protéger la batterie en fonction du résultat détecté ; dans lequel
le module de détection de pression est configuré en outre pour détecter, à un intervalle de temps prédéterminé, les relations de grandeur entre le paramètre de pression et une première valeur limite, une deuxième valeur limite et une troisième valeur limite qui augmentent progressivement ;
le module de génération d'instruction comprend une unité de génération d'alerte, une unité de génération de mise en veille, et une unité de génération de défaillance ;
l'unité de génération d'alerte (530a) est configurée pour générer une instruction d'affichage d'une information de rappel pour déclencher un appareil électronique afin qu'il émette une alerte de rappel par l'intermédiaire d'un écran d'affichage, d'un haut-parleur et/ou d'une lampe de signalisation, si le résultat détecté est que le paramètre de pression est supérieur à la première valeur limite et inférieur à la deuxième valeur limite ;
l'unité de génération de défaillance (530c) est configurée pour générer une instruction de défaillance permanente pour déclencher la batterie afin qu'elle passe sur un état de défaillance permanent, si le résultat détecté est que le paramètre de pression est supérieur à une troisième valeur limite ;**caractérisé en ce que** l'unité de génération de mise en veille (530b) est configurée pour générer une instruction de mise en veille pour déclencher la batterie afin qu'elle passe sur un état de veille, si le résultat détecté est que le paramètre de pression est supérieur à la deuxième valeur limite et inférieur à la troisième valeur limite ;
le module de génération d'instruction comprend en outre une unité de détection de pression et une unité de génération de reprise ;
l'unité de détection de reprise est configurée pour détecter que le paramètre de pression redevient inférieur à la deuxième valeur limite après que la batterie passe dans l'état de veille ; et
l'unité de génération de reprise est configurée pour générer une instruction de reprise après veille pour déclencher la batterie afin qu'elle revienne à un état fonctionnel normal après l'état de veille si le résultat détecté est que le paramètre de pression est inférieur à la deuxième valeur limite.

5. Dispositif électronique portable, **caractérisée en ce que** le dispositif électronique comprend :
un ou plusieurs processeurs ;
une mémoire ; et
un ou plusieurs modules de programme mémorisés dans la mémoire et configurés pour être exécutés par les un ou plusieurs processeurs, les un ou plusieurs modules de programme amenant les un ou plusieurs processeurs à exécuter les étapes de la revendication 3.

6. Produit de programme sur lequel sont mémorisées des instructions qui, à leur exécution par un ou plusieurs processeurs d'un dispositif électronique portable, amènent le dispositif électronique à exécuter les étapes de la revendication 3.
